(19) Europäisches Patentamt / European Patent Office / Office européen des brevets

(11) **EP 4 177 613 A1**

(12) **EUROPEAN PATENT APPLICATION**
published in accordance with Art. 153(4) EPC

(43) Date of publication:
**10.05.2023 Bulletin 2023/19**

(21) Application number: **20964557.1**

(22) Date of filing: **08.12.2020**

(51) International Patent Classification (IPC):
**G01R 15/16** (2006.01)

(52) Cooperative Patent Classification (CPC):
**G01R 15/16**

(86) International application number:
**PCT/CN2020/134698**

(87) International publication number:
**WO 2022/120612 (16.06.2022 Gazette 2022/24)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Huawei Digital Power Technologies
Co., Ltd.
Shenzhen, Guangdong 518043 (CN)**

(72) Inventors:
• WANG, Shuai
  **Shenzhen, Guangdong 518129 (CN)**
• YU, Jianwei
  **Shenzhen, Guangdong 518129 (CN)**
• ZHOU, Jie
  **Shenzhen, Guangdong 518129 (CN)**

(74) Representative: **Isarpatent
Patent- und Rechtsanwälte Barth
Charles Hassa Peckmann & Partner mbB
Friedrichstrasse 31
80801 München (DE)**

(54) **AC ELECTRICAL ENERGY DETECTION DEVICE**

(57) This application discloses an alternating-current energy detection apparatus, in which a voltage detection unit forms a coupling capacitance together with a tested cable, obtains a first voltage based on an actual voltage and the coupling capacitance, and outputs the first voltage to a data processing unit; a current detection unit detects a tested-cable current, and outputs the tested-cable current to the data processing unit; and the data processing unit receives the first voltage and the tested-cable current, and determines a first voltage value and a tested-cable current value; calculates a product of the first voltage value and a quantity of amplification times of a tested-cable voltage, and determines a tested-cable voltage value; and calculates, based on the tested-cable voltage value and the tested-cable current value, electric energy transmitted by the tested cable. The apparatus provided in this application can prevent an installation location of the detection apparatus from being limited by electrical connection points. In addition, there is no electrical connection between the detection apparatus and the tested cable. Under a premise of real-time detection of information such as an amplitude and a phase of a measured voltage and all harmonics of the tested cable, a production compliance level of the detection apparatus can be increased, and costs can be reduced.

FIG. 2

## Description

### TECHNICAL FIELD

This application relates to the field of electric energy detection, and in particular, to an alternating-current energy detection apparatus.

### BACKGROUND

An alternating-current energy detection apparatus detects an alternating-current voltage and an alternating current of a tested cable, and performs calculation on the alternating-current voltage and the alternating current to obtain electric energy transmitted by the tested cable, so as to collect statistics on the electric energy.

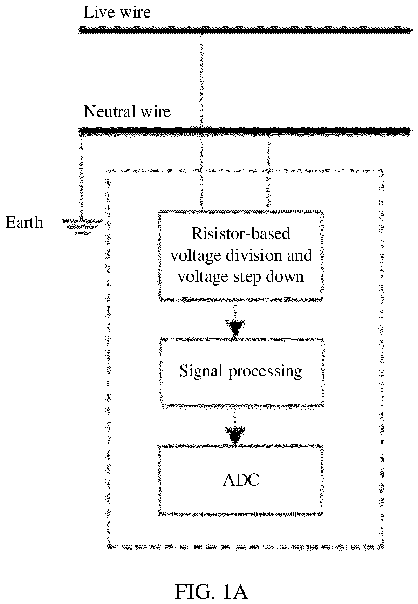

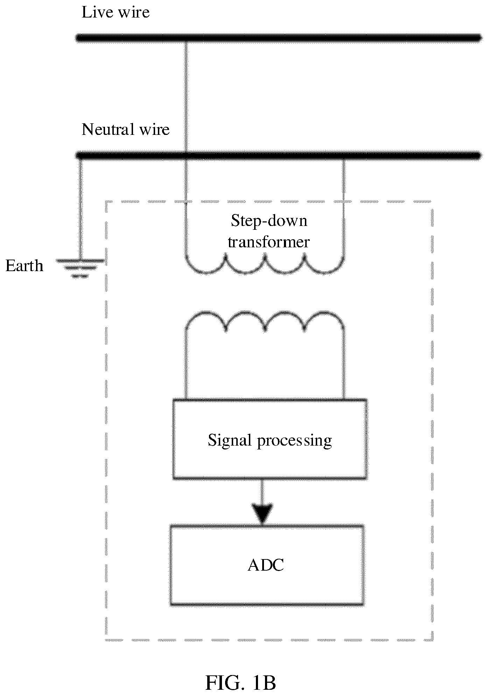

Usually, in an existing alternating-current energy detection apparatus, an alternating-current voltage detection part performs measurement by using a wire directly led out from a tested cable, for example, as shown in FIG. 1A and FIG. 1B.

Referring to FIG. 1A, electrical connection points for alternating-current voltage detection are specially reserved on a neutral wire and a live wire of the tested cable. In addition, after the wires are led out from the electrical connection points, voltage division and voltage step down are performed by using a resistor. Then, signal processing is performed. Finally, a processed signal is input into an ADC (analog to digital converter, analog to digital converter) to implement alternating-current voltage detection.

Referring to FIG. 1B, in existing alternating-current voltage detection, alternatively, wires may be led out from electrical connection points, and then connected to a step-down transformer. After the step-down transformer performs voltage step down, signal processing is performed. Finally, a processed signal is input into an ADC to implement alternating-current voltage detection.

However, in the foregoing two manners, dedicated electrical connection points for alternating-current voltage detection need to be reserved on the tested cable. Therefore, an installation location of the alternating-current energy detection apparatus is limited, and various issues such as production compliance and costs of electrical connection points also need to be considered.

### SUMMARY

This application provides an alternating-current energy detection apparatus, to prevent an installation location of the detection apparatus from being limited by electrical connection points. In addition, there is no electrical connection between the detection apparatus and a tested cable. Under a premise of real-time detection of information such as an amplitude and a phase of a measured voltage and all harmonics of the tested cable, a production compliance level of the detection apparatus can be increased, and costs can be reduced.

According to a first aspect, this application provides an alternating-current energy detection apparatus. The apparatus includes a voltage detection unit, a current detection unit, and a data processing unit. The voltage detection unit forms a coupling capacitance together with a tested cable, and is configured to obtain a first voltage based on an actual voltage of the tested cable and the coupling capacitance, and output the first voltage to the data processing unit. The current detection unit is configured to detect a tested-cable current, and output the tested-cable current to the data processing unit. The data processing unit is configured to receive the first voltage and the tested-cable current, and determine a first voltage value and a tested-cable current value; calculate a product of the first voltage value and a quantity of amplification times of a tested-cable voltage, and determine a tested-cable voltage value; and calculate, based on the tested-cable voltage value and the tested-cable current value, electric energy transmitted by the tested cable.

In view of this, the alternating-current energy detection apparatus provided in this application can prevent a problem that an installation location of the alternating-current energy detection apparatus is limited by electrical connection points used for performing alternating-current voltage and current detection. In addition, there is no electrical connection between the alternating-current energy detection apparatus and the tested cable. Under a premise of real-time detection of information such as an amplitude and a phase of a measured voltage and all harmonics of the tested cable, a production compliance level of the detection apparatus can be increased, and costs of the alternating-current energy detection apparatus can be reduced.

In a possible implementation, the voltage detection unit includes a voltage sensor, an amplification circuit, and a phase-shift compensation circuit. The amplification circuit includes a first input port, a second input port, and a first output port. The first input port is connected to the voltage sensor, the second input port is connected to a ground cable, and the first output port is connected to the phase-shift compensation circuit. The voltage sensor is a conductive tubular structure, the tested cable runs through the voltage sensor, and the voltage sensor forms a coupling capacitance together with the tested cable. The voltage sensor is configured to generate an inducting voltage based on the actual voltage of the tested cable and the coupling capacitance. The amplification circuit is configured to amplify the inducting voltage by a first quantity of times, and output a second voltage to the phase-shift compensation circuit by using the output port. The phase-shift compensation circuit is configured to perform a phase shift on the second voltage, amplify the second voltage by a second quantity of times, and output the first voltage.

The voltage sensor is configured to form the coupling capacitance together with the tested cable, so that the alternating-current energy detection apparatus detects, in a non-contact manner, the actual voltage transmitted by the tested cable. When the actual voltage is specifically detected, the inducting voltage is generated on the voltage sensor. However, the inducting voltage is excessively small and difficult to be identified and detected by the data processing unit. The amplification circuit may be configured to amplify the inducting voltage. The amplification circuit may be but is not limited to a reverse amplification circuit or a differential amplification circuit. In addition, because the inducting voltage is obtained based on capacitive coupling, a phase of the inducting voltage generated from the actual voltage of the tested cable by using the coupling capacitance is 90° behind a current. Therefore, the phase-shift compensation circuit needs to be configured to lag the phase of the inducting voltage by another 90°, so that a voltage phase output by the phase-shift compensation circuit is adjusted to be consistent with a phase of the actual voltage of the tested cable. In addition, the phase-shift compensation circuit may be further configured to re-amplify a voltage amplified by the amplification circuit, so that the voltage is more easily identified and detected by the data processing unit.

In a possible implementation, the voltage sensor is a closed or non-closed tubular structure. The voltage sensor is prepared by using a metal material.

To ensure an effect of capacitive coupling, the voltage sensor may be a metal material, and the metal material may be copper, aluminum, or the like. For example, the voltage sensor may be foil of a copper material, and the copper foil may be rolled up to be closed or non-closed. After the copper foil is sleeved outside the tested cable, a coupling capacitance is generated between the tested cable and the copper foil. In addition, the voltage sensor may further be a polygonal tubular structure such as a square tubular structure or a rectangular tubular structure. In addition, the voltage sensor may alternatively be a non-tubular structure with metal bipolar plates. The metal bipolar plates are disposed on two sides of the tested cable, so that the tested cable runs through the metal bipolar plates, and the metal bipolar plates form a coupling capacitance together with the tested cable.

In a possible implementation, the voltage detection unit further includes a single-pole double-throw switch and an effective-value detection circuit. The single-pole double-throw switch includes a second output port, a ground port, and a preset-voltage input port. The single-pole double-throw switch is bridged between the second input port and the ground cable, the second output port is connected to the second input port, the preset-voltage input port is configured to receive an input preset voltage, and the ground port is connected to the ground cable. The amplification circuit includes a sub-amplification circuit and a subtractive operation circuit. The sub-amplification circuit includes a third input port, a fourth input port, and a third output port. The subtractive operation circuit includes a fifth input port, a sixth output port, and a fourth output port. The first input port is connected to the third input port, the second input port is separately connected to the fourth input port and the sixth input port, the third output port is connected to the fifth input port, and the fourth output port is connected to the first output port. The first output port is further connected to the effective-value detection circuit. When the second output port is conducted to the ground port, the sub-amplification circuit is configured to amplify the inducting voltage by the first quantity of times, and output the second voltage to the phase-shift compensation circuit. When the second output port is conducted to the preset-voltage input port, the sub-amplification circuit is configured to perform differential amplification on the inducting voltage and the preset voltage by the first quantity of times to obtain a third voltage, and the subtractive operation circuit is configured to calculate a difference between the third voltage and the preset voltage to obtain a fourth voltage, and output the fourth voltage to the effective-value detection circuit by using the first output port. The effective-value detection circuit is configured to receive the fourth voltage, separately extract a component of the tested-cable voltage and a component of the preset voltage from the fourth voltage, determine an effective value of the tested-cable voltage based on the component of the tested-cable voltage and the component of the preset voltage, and send the effective value of the tested-cable voltage to the data processing unit. The data processing unit is specifically configured to receive the effective value of the tested-cable voltage; and determine the quantity of amplification times of the tested-cable voltage based on a ratio of an effective value of the first voltage to the effective value of the tested-cable voltage.

In some use scenarios, a size of the coupling capacitance $C_x$ varies with an environmental change. In actual measurement, it cannot be ensured that a location of the tested cable in the voltage sensor is fixed and unchanged at each time of measurement. In addition, because a thickness of a sheath of the tested cable is non-uniform, and a radius of the tested cable is also unfixed, the size of the coupling capacitance is difficult to be directly measured. In addition, an environmental change also leads to a change of a dielectric constant of a dielectric between the voltage sensor and the tested cable. Therefore, the coupling capacitance is not a known quantity that can be directly calculated.

In view of this, after relative locations of the voltage sensor and the tested cable are fixed, the voltage detection unit needs to be calibrated, so as to indirectly obtain a correspondence between the actual voltage of the tested cable and the first voltage (the inducting voltage), that is, the quantity of amplification times of the tested-cable voltage. In this way, after the voltage detection unit is calibrated each time, the tested-cable voltage value can be obtained based on the first voltage.

Because the size of the coupling capacitance is difficult to be directly measured, the coupling capacitance can be equivalently expressed in the correspondence between the actual voltage and the first voltage. Specifically, after the alternating-current energy detection apparatus is installed on the tested cable and a location is fixed, the alternating-current energy detection apparatus may be calibrated. After the second output port is conducted to the preset-voltage input port, the sub-amplification circuit in the amplification circuit simultaneously inputs a preset voltage whose voltage amplitude and voltage frequency are known and an inducting voltage corresponding to the actual voltage, so that the sub-amplification circuit outputs the third voltage. There are three voltage components in the third voltage, two of the voltage components are components of the preset voltage in different phases, and the other is a component of the actual voltage. Due to existence of the components of the preset voltage in different phases, the subtractive operation circuit is required to filter out a component that is one of the two components of the preset voltage in different phases and whose phase is different from a phase of the component of the actual voltage, so as to obtain the fourth voltage; and then input the fourth voltage into the effective-value detection circuit in this case, so that an effective value of the actual voltage of the tested cable can be determined. After the second output port is conducted to the ground cable, the voltage detection unit outputs the first voltage, and determines, based on the first voltage and the effective value of the actual voltage of the tested cable, a correspondence between the effective value of the actual voltage of the tested cable and the effective value of the first voltage, that is, the quantity of amplification times of the tested-cable voltage, so as to eliminate impact caused by a change of the coupling capacitance. In the foregoing scenario, after extracting the component of the tested-cable voltage and the component of the preset voltage, the effective-value detection circuit can calculate a median value. Effective-value detection circuits with different structures output different median values, but there is a linear relationship between each of the median values and the effective value of the tested-cable voltage. A person skilled in the art should know various structures of effective-value detection circuits.

In a possible implementation, the apparatus further includes a power supply unit. The power supply unit is configured to supply power to the voltage detection unit and the data processing unit.

To ensure that the alternating-current energy detection apparatus can work normally, the power supply unit may be an external power supply. The external power supply can supply power to the voltage detection unit, the current detection unit, and the data processing unit in the alternating-current energy detection apparatus. However, a manner of using an external power supply leads to a relatively complex power supply form, and the alternating-current energy detection apparatus is limited by a location of the power supply and can perform detection only near the power supply. The alternating-current energy detection apparatus may use a built-in battery for power supply, but a battery has a service life problem and needs to be repeatedly replaced.

In view of this, to resolve a problem that the alternating-current energy detection apparatus is limited by a location of the power supply or a problem that a battery needs to be repeatedly replaced, in a possible implementation, the power supply unit includes a power-draw transformer, a filtering and rectification circuit, and an electric energy management unit. The power-draw transformer is configured to generate an induced current based on an actual current of the tested cable, and output the induced current to the filtering and rectification circuit. The filtering and rectification circuit is configured to perform filtering and rectification on the induced current to obtain a power-supply current. The electric energy management unit is configured to separately supply power to the voltage detection unit, the current detection unit, and the processing unit by using the power-supply current.

To enable the installation location of the entire alternating-current energy detection apparatus to be free from limitation, the power supply unit of the alternating-current energy detection apparatus may alternatively be designed into a non-contact manner for power drawing. In this way, the alternating-current energy detection apparatus is also not limited by a location of an external power supply, and can work normally at any location of the tested cable.

In a possible implementation, the power-draw transformer is a toroidal iron core wound with at least one turn of coil. The toroidal iron core is a closed or non-closed structure, and the at least one turn of coil is configured to be connected to the filtering and rectification circuit. A principle of the power-draw transformer is similar to that of a common current transformer, but specific parameter settings are different, for example, a quantity of turns of coils winding the toroidal iron core is different. The induced current varies with a different quantity of turns, so that different coil-turn ratios can be set based on different power supply requirements.

In a possible implementation, the electric energy management unit is a DC/DC circuit. The DC/DC conversion circuit may include components such as a switching transistor, a diode, an inductor, and a capacitor. A work status of the DC/DC conversion circuit may be implemented by adjusting work statuses of these components. The work status of the DC/DC conversion circuit may be: converting received electric energy into a voltage that is suitable for the voltage detection unit, the current detection unit, and the data processing unit. Specifically, the switching transistor in the DC/DC conversion circuit is a metal oxide semiconductor transistor, or may be a bipolar junction transistor, or certainly may be another component that can implement a switching function. In addition, the electric energy management unit may further include a battery module. The DC/DC conversion circuit converts received electric energy and outputs the converted electric energy to the battery module. In this case, the DC/DC conversion circuit is in a charging state. In addition, when the voltage detection unit, the current detection unit, and the data processing unit are in a working state, the DC/DC conversion circuit converts electric energy stored in the battery module into a voltage that is suitable for the voltage detection unit, the current detection unit, and the data processing unit for output. In this case, the DC/DC conversion circuit is in a discharging state. A battery unit is designed in the power supply unit, so that the power supply unit of the alternating-current energy detection apparatus can temporarily store electric energy. When the alternating-current energy detection apparatus needs to perform voltage detection, the battery unit can supply power to the alternating-current energy detection apparatus.

According to a second aspect, this application provides an alternating-current voltage detection apparatus. The apparatus includes a voltage detection unit and a data processing unit. The voltage detection unit forms a coupling capacitance together with a tested cable, and is configured to obtain a first voltage based on an actual voltage of the tested cable and the coupling capacitance, and output the first voltage to the data processing unit. The data processing unit is configured to receive the first voltage and determine a first voltage value; and calculate a product of the first voltage value and a quantity of amplification times of a tested-cable voltage, and determine a tested-cable voltage value.

In a possible implementation, the voltage detection unit includes a voltage sensor, an amplification circuit, and a phase-shift compensation circuit. The amplification circuit includes a first input port, a second input port, and a first output port. The first input port is connected to the voltage sensor, the second input port is connected to a ground cable, and the first output port is connected to the phase-shift compensation circuit. The voltage sensor is a conductive tubular structure, the tested cable runs through the voltage sensor, and the voltage sensor forms a coupling capacitance together with the tested cable. The voltage sensor is configured to generate an inducting voltage based on the actual voltage of the tested cable and the coupling capacitance. The amplification circuit is configured to amplify the inducting voltage by a first quantity of times, and output a second voltage to the phase-shift compensation circuit by using the output port. The phase-shift compensation circuit is configured to perform a phase shift on the second voltage, amplify the second voltage by a second quantity of times, and output the first voltage.

In a possible implementation, the phase-shift compensation circuit is specifically configured to lag a phase of the second voltage by 90°.

In a possible implementation, the voltage sensor is a closed or non-closed tubular structure. The voltage sensor is prepared by using a metal material.

In a possible implementation, the voltage detection unit further includes a single-pole double-throw switch and an effective-value detection circuit. The single-pole double-throw switch includes a second output port, a ground port, and a preset-voltage input port. The single-pole double-throw switch is bridged between the second input port and the ground cable, the second output port is connected to the second input port, the preset-voltage input port is configured to receive an input preset voltage, and the ground port is connected to the ground cable. The amplification circuit includes a sub-amplification circuit and a subtractive operation circuit. The sub-amplification circuit includes a third input port, a fourth input port, and a third output port. The subtractive operation circuit includes a fifth input port, a sixth output port, and a fourth output port. The first input port is connected to the third input port, the second input port is separately connected to the fourth input port and the sixth input port, the third output port is connected to the fifth input port, and the fourth output port is connected to the first output port. The first output port is further connected to the effective-value detection circuit. When the second output port is conducted to the ground port, the sub-amplification circuit is configured to amplify the inducting voltage by the first quantity of times, and output the second voltage to the phase-shift compensation circuit. When the second output port is conducted to the preset-voltage input port, the sub-amplification circuit is configured to perform differential amplification on the inducting voltage and the preset voltage by the first quantity of times to obtain a third voltage, and the subtractive operation circuit is configured to calculate a difference between the third voltage and the preset voltage to obtain a fourth voltage, and output the fourth voltage to the effective-value detection circuit by using the first output port. The effective-value detection circuit is configured to receive the fourth voltage, separately extract a component of the tested-cable voltage and a component of the preset voltage from the fourth voltage, determine an effective value of the tested-cable voltage based on the component of the tested-cable voltage and the component of the preset voltage, and send the effective value of the tested-cable voltage to the data processing unit. The data processing unit is specifically configured to receive the effective value of the tested-cable voltage; and determine the quantity of amplification times of the tested-cable voltage based on a ratio of an effective value of the first voltage to the effective value of the tested-cable voltage.

In a possible implementation, the apparatus further includes a power supply unit. The power supply unit is configured to supply power to the voltage detection unit and the data processing unit.

In a possible implementation, the power supply unit includes a power-draw transformer, a filtering and rectification circuit, and an electric energy management unit. The power-draw transformer is configured to generate an induced current based on a current of the tested cable, and output the induced current to the filtering and rectification circuit. The filtering and rectification circuit is configured to perform filtering and rectification on the induced current to obtain a power-supply current. The electric energy management unit is configured to separately supply power to the voltage detection unit and the processing unit by using the power-supply current.

In a possible implementation, the power-draw transformer is a toroidal iron core wound with at least one turn of coil, the toroidal iron core is a closed or non-closed structure, and the at least one turn of coil is configured to be connected to the filtering and rectification circuit. The electric energy management unit is a direct current-to-direct current DC/DC circuit.

According to a third aspect, this application provides an alternating-current energy detection method. The method includes: receiving a first voltage and a tested-cable current, and determining a first voltage value and a tested-cable current value; calculating a product of the first voltage value and a quantity of amplification times of a tested-cable voltage, and determining a tested-cable voltage value; and calculating, based on the tested-cable voltage value and the tested-cable current value, electric energy transmitted by a tested cable.

In a possible implementation, the method further includes: receiving an effective value of the tested-cable voltage; and determining the quantity of amplification times of the tested-cable voltage based on a ratio of an effective value of the first voltage to the effective value of the tested-cable voltage.

According to a fourth aspect, this application provides an alternating-current voltage detection method. The method includes: receiving a first voltage, and determining a first voltage value; and calculating a product of the first voltage value and a quantity of amplification times of a tested-cable voltage, and determining a tested-cable voltage value.

In a possible implementation, the method further includes: receiving an effective value of the tested-cable voltage; and determining the quantity of amplification times of the tested-cable voltage based on a ratio of an effective value of the first voltage to the effective value of the tested-cable voltage.

For beneficial effects of each possible design in the second aspect to the fourth aspect of this application, refer to the first aspect. Details are not described herein again.

**BRIEF DESCRIPTION OF DRAWINGS**

FIG. 1A is a schematic diagram of a structure of a circuit for detecting a voltage by means of resistor voltage division;
FIG. 1B is a schematic diagram of a structure of a circuit for detecting a voltage by using a step-down transformer;
FIG. 2 is a schematic diagram of a structure of an alternating-current energy detection apparatus;
FIG. 3A is a schematic diagram of a structure of a voltage detection unit;
FIG. 3B is a schematic diagram of a structure of a voltage sensor;
FIG. 3C is a schematic diagram of a structure of a reverse amplification circuit;
FIG. 3D is a schematic diagram of a structure of a phase-shift compensation circuit;
FIG. 4A is a schematic diagram of a structure of another voltage detection unit;
FIG. 4B is a schematic diagram of a structure of an amplification circuit;
FIG. 4C is a flowchart of a procedure for detecting a tested-cable voltage;
FIG. 5A is a schematic diagram of a structure for supplying power by using an external power supply;
FIG. 5B is a schematic diagram of a structure for supplying power by using a battery;
FIG. 5C is a schematic diagram of an installation structure of a power supply unit;
FIG. 5D is a schematic diagram of an equivalent of a power supply unit; and
FIG. 6 is a schematic diagram of a structure of an alternating-current voltage detection apparatus.

**DESCRIPTION OF EMBODIMENTS**

To make objectives, technical solutions, and advantages of this application clearer, the following further describes this application in detail with reference to the accompanying drawings. An alternating-current energy detection apparatus provided in the embodiments of this application may be configured to measure electric energy transmitted by a cable. The cable is applied to various power grids for electric energy transmission. The power grid may be a city power grid, a photovoltaic power grid, a micro power grid, a household power grid, an industrial power grid, or the like. Electric energy transmitted by the foregoing power grid may be a high-frequency alternating current or a low-frequency alternating current, and may be high voltage or low voltage. Electric energy transmitted by a cable mainly depends on a specific type of a power grid. This is not limited in the embodiments of this application.

It should be noted that in the description of this application, "at least one" means one or more, and "a plurality of" means two or more. In view of this, "a plurality of" may also be understood as "at least two" in the embodiments of this application. The term "and/or" describes an association relationship for describing associated objects and represents that three relationships may exist. For example, A and/or B may represent the following three cases: Only A exists, both A and B exist, and only B exists. In addition, the character "/", unless otherwise specified, generally indicates an "or" relationship between the associated objects. In addition, it should be understood that in the descriptions of this application, words such as "first" and "second" are merely used for distinguished descriptions, and cannot be understood as an indication or implication of relative importance, and cannot be understood as an indication or implication of a sequence.

The following first explains some terms used in the embodiments of this application, for ease of understanding by a person skilled in the art.

(1) Production compliance level (production compliance level): Production compliance is requirements for product safety in product certification, including safety requirements on product parts and safety requirements on a finished product obtained after assembly. Hazards that may be caused by a product in normal or abnormal use, such as electric shock, fire, mechanical injury, thermal injury, chemical injury, radiation injury, and food hygiene are assessed by simulating usage and performing a series of tests.

(2) Capacitive coupling: also referred to as electric field coupling or electrostatic coupling, is a coupling manner brought forth by existence of distributed capacitance. Specifically, in a direct-current circuit, a capacitor is equivalent to an open circuit that no current can pass through. In an alternating-current circuit, as a voltage at a pin of a capacitor gradually increases, electric charge accumulated on a plate electrode connected to the pin also gradually increases; and as the voltage gradually decreases, the electric charge accumulated on the corresponding plate electrode also gradually decreases. In this whole process, it seems that a current passes through the capacitor, but actually there is not any current. Therefore, a coupling capacitance can approximately complete current transmission from a former stage to a latter stage in this manner in an alternating-current circuit.

To facilitate understanding of the alternating-current energy detection apparatus provided in the embodiments of this application, the following first describes an application scenario of the alternating-current energy detection apparatus. The alternating-current energy detection apparatus can detect an alternating-current voltage and an alternating current of a tested cable, and obtain, by means of specific calculation, electric energy transmitted by the cable for statistics collection on the electric energy. Usually, in an existing alternating-current energy detection apparatus, an alternating-current voltage detection part performs measurement by using electric connection points directly led out from a tested cable. After the electrical connection points are led out, the tested cable may be connected to a resistor voltage divider circuit to perform voltage division and voltage step down. Then, signal processing is performed. Alternatively, after the electrical connection points are led out, the tested cable is connected to a step-down transformer. The step-down transformer performs voltage step down. Then, signal processing is performed. Finally, an alternating-current voltage value of the tested cable is obtained.

However, in the foregoing manner of detection by leading out electrical connection points, when the alternating-current energy detection apparatus performs electric energy detection, a detection location is limited by electrical connection points led out from a neutral wire and a live wire of the tested cable, and an insulation issue for production compliance of the cable also needs to be considered after the electrical connection points are set. In addition, in the manner of detection by leading out electrical connection points, a resistor voltage divider circuit or a step-down transformer is necessarily disposed to reduce a voltage of the tested cable for ease of detection. As a result, the resistor voltage divider circuit or the step-down transformer further increases a volume and costs of the alternating-current energy detection apparatus and brings inconvenience to a detection person.

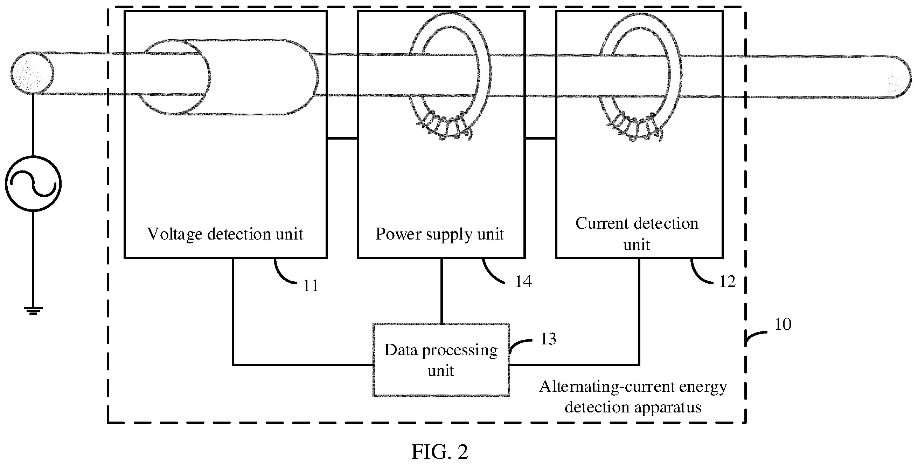

In view of this, the alternating-current energy detection apparatus needs to be further improved to increase a production compliance level of the alternating-current energy detection apparatus, simplify the alternating-current energy detection apparatus, and reduce costs, so that a detection person can detect alternating-current energy in a non-contact electrical connection manner. The following embodiments are described by using single-phase voltage detection as an example. However, an alternating-current energy detection apparatus described in the following embodiments may also be used in a three-wire system scenario and a dual-live wire scenario. In the foregoing scenarios, a method for using an alternating-current energy detection apparatus is only a simple combination of single-phase scenarios. Details are not described herein again. FIG. 2 shows an alternating-current energy detection apparatus. The alternating-current energy detection apparatus 10 includes a voltage detection unit 11, a current detection unit 12, and a data processing unit 13.

The following describes functions of the units in a process in which the apparatus detects electric energy transmitted by a tested cable.

The voltage detection unit 11 forms a coupling capacitance together with the tested cable, and is configured to obtain a first voltage based on an actual voltage of the tested cable and the coupling capacitance, and output the first voltage to the data processing unit 13. The current detection unit 12 is configured to detect a tested-cable current, and output the tested-cable current to the data processing unit 13. The data processing unit 13 is configured to receive the first voltage and the tested-cable current, and determine a first voltage value and a tested-cable current value; calculate a product of the first voltage value and a quantity of amplification times of a tested-cable voltage, and determine a tested-cable voltage value; and calculate, based on the tested-cable voltage value and the tested-cable current value, the electric energy transmitted by the tested cable.

The voltage detection unit 11 is specifically configured to detect a voltage of the tested cable. A voltage detection manner is implemented by using a voltage sensor instead of directly leading out a wire from the cable, so as to greatly increase a production compliance level of the alternating-current energy detection apparatus. For a specific voltage detection manner, refer to content described in the following embodiments.

The current detection unit 12 may include a current transformer (current transformer, CT). The current transformer is an instrument that converts, based on a principle of electromagnetic induction, a primary-side current into a secondary-side current for measurement. The current transformer includes a closed iron core and a winding. A primary-side winding of the current transformer has a very small quantity of turns (in this application, the primary-side winding is a cable). The primary-side winding is connected in series to a line whose current needs to be measured, and the current transformer is sleeved around the tested cable, and a current of the tested cable is detected based on a principle of electromagnetic mutual inductance. Specifically, a magnetic field is generated around the tested cable. After the current transformer is sleeved around the tested cable, a coil of the current transformer generates an induced current due to the magnetic field of the tested cable. After the induced current is amplified, the tested-cable current can be obtained.

The data processing unit 13 may be a processor or a controller, for example, may be a central processing unit (central processing unit, CPU), a general-purpose processor, a digital signal processor (digital signal processor, DSP), an application-specific integrated circuit (application specific integrated circuit, ASIC), a field programmable gate array (field programmable gate array, FPGA) or another programmable logic device, a transistor logic device, a hardware component, or any combination thereof. The processing unit may implement or execute various example logical blocks, modules, and circuits described with reference to content disclosed in this application. The processor may also be a combination for implementing a computing function, for example, a combination including one or more microprocessors, a combination of a DSP and a microprocessor, or the like. In addition, the data processing unit 13 may further include an analog to digital converter (analog digital converter, ADC), configured to convert analog parameters input by the voltage detection unit 11 and the current detection unit 12 into digital parameters.

After receiving the first voltage and the tested-cable current, the data processing unit 13 can determine the first voltage value and the tested-cable current value by using the ADC, and calculate the product of the first voltage value and the quantity of amplification times of the tested-cable voltage to obtain the tested-cable voltage value. When performing voltage detection, the voltage detection unit 11 reduces the actual voltage of the tested cable by a specific proportion and output the first voltage. The tested-cable voltage value can be obtained by amplifying the first voltage by the quantity of amplification times of the cable voltage. Transmitted electrical power of the tested cable is determined based on the tested-cable voltage value and the tested-cable current value, and further, the electric energy transmitted by the tested cable is determined based on a transmission time and the transmitted electrical power.

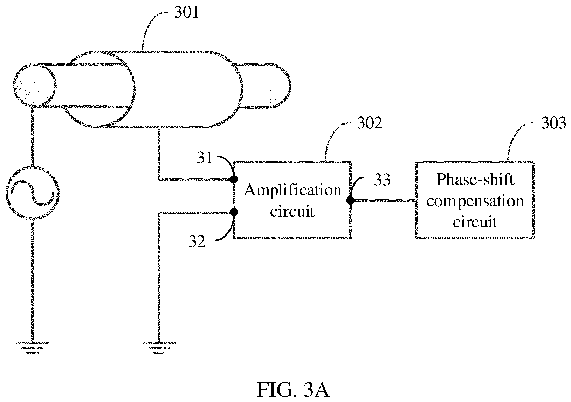

In a possible implementation, FIG. 3A is a schematic diagram of a structure of a voltage detection unit. The voltage detection unit 11 includes a voltage sensor 301, an amplification circuit 302, and a phase-shift compensation circuit 303. The amplification circuit 302 includes a first input port 31, a second input port 32, and a first output port 33. The first input port 31 is connected to the voltage sensor 301, the second input port 32 is connected to a ground cable, and the first output port 33 is connected to the phase-shift compensation circuit 303.

The voltage sensor 301 is a conductive tubular structure, the tested cable runs through the voltage sensor 301, and the voltage sensor 301 forms a coupling capacitance together with the tested cable. The voltage sensor 301 is configured to generate an inducting voltage based on the actual voltage of the tested cable and the coupling capacitance.

The amplification circuit 302 is configured to amplify the inducting voltage by a first quantity of times, and output a second voltage to the phase-shift compensation circuit by using the output port.

The phase-shift compensation circuit 303 is configured to perform a phase shift on the second voltage, amplify the second voltage by a second quantity of times, and output the first voltage.

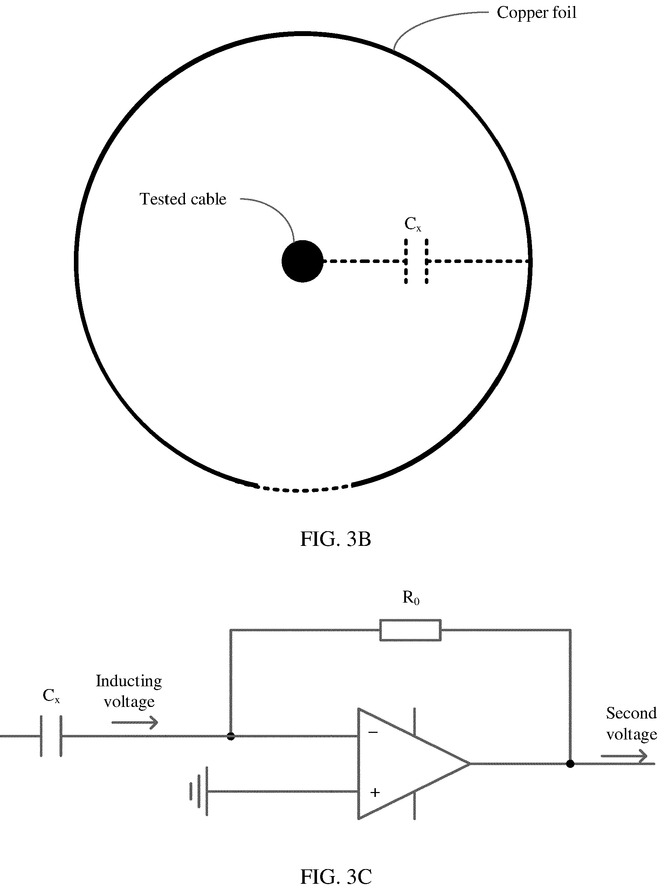

In a possible implementation, the voltage sensor 301 is a closed or non-closed tubular structure. The voltage sensor is prepared by using a metal material. The metal material may be copper, aluminum, or the like. Specifically, in this application, FIG. 3B is a schematic diagram of a structure of a voltage sensor. The voltage sensor 301 is foil of a copper material, and the copper foil may be rolled up to be closed or non-closed. After the copper foil is sleeved outside the tested cable, a coupling capacitance $C_x$ is generated between the tested cable and the copper foil. In addition, in an actual alternating-current energy detection scenario, $C_x$ varies with an external environment condition such as a location of the tested cable in the voltage sensor 301 or a cable diameter, and therefore is difficult to be measured.

Alternatively, the voltage sensor 301 may not be the cylindrical structure shown in FIG. 3B, and may be a polygonal tubular structure such as a square tubular structure or a rectangular tubular structure. In addition, the voltage sensor may alternatively be a non-tubular structure with metal bipolar plates. Specifically, the metal bipolar plates may be disposed on two sides of the tested cable, so that the tested cable runs through the metal bipolar plates, and the metal bipolar plates form a coupling capacitance $C_x$ together with the tested cable.

After the voltage sensor 301 and the tested cable form the coupling capacitance $C_x$, an alternating-current voltage of the tested cable and the coupling capacitance can form, by using capacitive coupling, the inducting voltage to be input into the amplification circuit 302. However, because the inducting voltage is excessively small and is difficult to be identified and detected by the ADC in the data processing unit 13, the amplification circuit 302 is required to amplify the inducting voltage to obtain the second voltage $V_2$. The amplification circuit may be but is not limited to a reverse amplification circuit or a differential amplification circuit. A reverse amplification circuit is used as an example herein. FIG. 3C is a schematic diagram of a structure of a reverse amplification circuit. A first quantity of times of amplification of the reverse amplification circuit is related to a feedback resistance Ro in the reverse amplification circuit. A larger feedback resistance $R_0$, the larger quantity of amplification times. This should be known by a person skilled in the art, and details are not described herein.

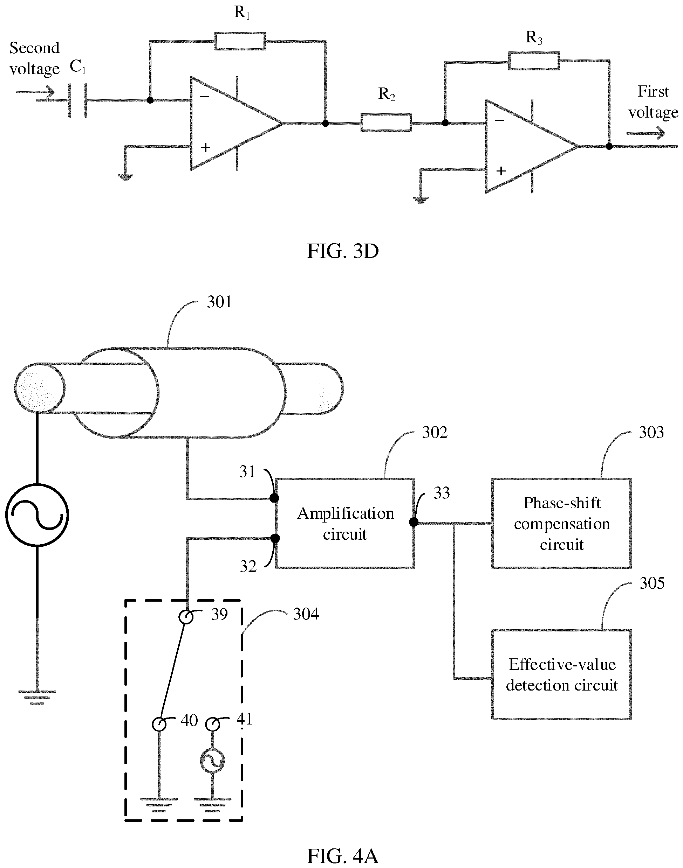

The phase-shift compensation circuit 303 is configured to perform a phase shift on the second voltage $V_2$, amplify the second voltage by a second quantity of times, and finally output the first voltage $V_1$. FIG. 3D is a schematic diagram of a structure of a phase-shift compensation circuit. A function of the phase-shift compensation circuit 303 of amplifying the second voltage $V_2$ by the second quantity of times is similar to a function of amplifying the inducting voltage by the first quantity of times, and is also used to further amplify the second voltage, so that the second voltage is more easily identified by the ADC in the data processing unit 13. The second quantity of times of amplification of the amplification circuit 302 is related to feedback resistances $R_1$, $R_2$, and $R_3$ in the reverse amplification circuit. In addition, because the inducting voltage is a voltage obtained by using capacitive coupling, according to a nature of the coupling capacitance, a voltage is directly proportional to electric charge and inversely proportional to a capacity, and the voltage is a result of electric charge accumulation. Therefore, the voltage does not change abruptly whereas a current may change abruptly, and a phase of the current is ahead of that of the voltage. In an alternating-current steady-state circuit, a phase of a voltage passing through a capacitor is 90° behind that of a current. A phase of the inducting voltage is 90° behind a phase of the actual voltage of the tested cable, and a phase of the second voltage $V_2$ obtained by amplifying the inducting voltage is also 90° behind. Therefore, to ensure that phase information of the actual voltage of the tested cable is not lost, the phase of the second voltage $V_2$ obtained by amplifying the inducting voltage needs to be compensated for, so as to restore the phase information of the actual voltage. As an optional implementation, the phase-shift compensation circuit is specifically configured to lag a phase of the second voltage by 90° by using a capacitor $C_1$. Because the second voltage $V_2$ is obtained by reversely amplifying the inducting voltage, after the inducting voltage is amplified by the reverse amplification circuit, the phase of the second voltage changes by 180° compared with that of the inducting voltage, and the phase of the inducting voltage is already 90° behind that of the actual voltage. Therefore, by using the capacitor $C_1$ in the phase-shift compensation circuit to lag the phase of the second voltage by another 90°, a phase of the first voltage $V_1$ output by the phase-shift compensation circuit can be adjusted to be consistent with the phase of the actual voltage of the tested cable.

In conclusion, after the first quantity of times, the second quantity of times, and the first voltage $V_1$ are known, a size of the inducting voltage can be inversely calculated. The tested-cable voltage value can be determined based on a correspondence between the inducting voltage and the actual voltage of the tested cable. The correspondence is related to a size of the coupling capacitance $C_x$. This should be known by a person skilled in the art, and details are not described herein. When the coupling capacitance $C_x$ is considered as a fixed value, the correspondence between the inducting voltage and the actual voltage of the tested cable can be obtained, so as to determine the tested-cable voltage value.

However, in some detection scenarios, the coupling capacitance $C_x$ varies with an environmental change. Referring to the following formula, the size of the coupling capacitance depends on the following parameters:

$$C_x = \frac{\varepsilon \cdot S}{d}$$

$C_x$ is the coupling capacitance, $\varepsilon$ is a dielectric constant of a dielectric, $S$ is an area of a metal plate, and $d$ is a spacing between metal plates.

Still referring to FIG. 3B, the voltage sensor 301 in this embodiment may be a conductive tubular structure. Therefore, the spacing $d$ between the metal plates is related to the location of the tested cable in the voltage sensor 301. However, in actual measurement, it cannot be ensured that the location of the tested cable in the voltage sensor 301 is fixed and unchanged at each time of measurement. In addition, because a thickness of a sheath of the tested cable is non-uniform, and a radius of the tested cable is also unfixed, the size of the coupling capacitance $C_x$ is difficult to be directly measured. In addition, an environmental change also leads to a change of a dielectric constant of a dielectric between the voltage sensor 301 and the tested cable. Therefore, the coupling capacitance $C_x$ is not a known quantity that can be directly measured. Based on the foregoing reasons, after locations of the voltage sensor and the tested cable are fixed, the voltage detection unit 11 needs to be calibrated, so as to prevent a problem of inaccurate measurement of the tested-cable voltage caused by a change of the coupling capacitance $C_x$, and finally, a correspondence between the actual voltage of the tested cable and the first voltage $V_1$ (the inducting voltage) can be directly obtained. In this way, after the voltage detection unit 11 is calibrated each time, the tested-cable voltage value can be obtained based on the first voltage $V_1$.

Optionally, FIG. 4A is a schematic diagram of a structure of another voltage detection unit. The voltage detection unit 11 further includes a single-pole double-throw switch 304 and an effective-value detection circuit 305. The single-pole double-throw switch 304 includes a second output port 39, a ground port 40, and a preset-voltage input port 41. The single-pole double-throw switch 304 is bridged between the second input port 32 and the ground cable. The second output port 39 is connected to the second input port 32, the preset-voltage input port 41 is configured to receive an input preset voltage $V_r$, and the ground port is connected to the ground cable.

The effective-value detection circuit 305 is configured to receive a fourth voltage $V_4$, separately extract a component of the tested-cable voltage and a component of the preset voltage from the fourth voltage $V_4$, determine an effective value of the tested-cable voltage based on the component of the tested-cable voltage and the component of the preset voltage, and send the effective value of the tested-cable voltage to the data processing unit 13.

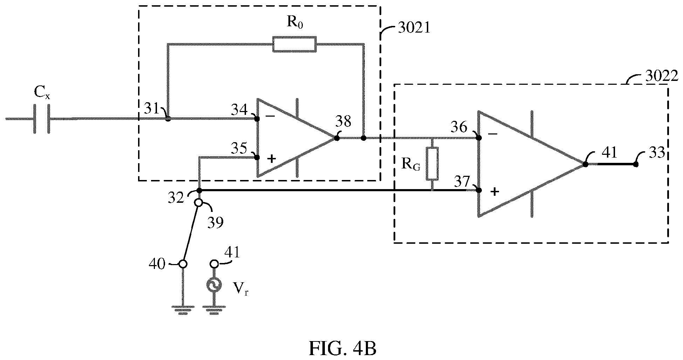

Based on the amplification circuit shown in FIG. 3A, FIG. 4B is a schematic diagram of an internal structure of another amplification circuit. The amplification circuit 302 may include a sub-amplification circuit 3021 and a subtractive operation circuit 3022.

The sub-amplification circuit 3021 may be a reverse amplification circuit, and the sub-amplification circuit 3021 includes a third input port 34, a fourth input port 35, and a third output port 38. The subtractive operation circuit 3022 includes a fifth input port 36, a sixth output port 37, and a fourth output port 41. The first input port 31 is connected to the third input port 34, the second input port 32 is separately connected to the fourth input port 35 and the sixth input port 37, the third output port 38 is connected to the fifth input port 36, and the fourth output port 41 is connected to the first output port 33. The first output port 33 is further connected to the effective-value detection circuit 305.

When the second output port 32 is conducted to the ground port 40, the sub-amplification circuit 3021 is configured to amplify the inducting voltage by the first quantity of times, and output the second voltage $V_2$ to the phase-shift compensation circuit. When the second output port is conducted to the preset-voltage input port, the sub-amplification circuit is configured to perform differential amplification on the inducting voltage and the preset voltage by the first quantity of times to obtain a third voltage $V_3$, and the subtractive operation circuit 3022 is configured to calculate a difference between the third voltage $V_3$ and the preset voltage to obtain the fourth voltage $V_4$, and output the fourth voltage $V_4$ to the effective-value detection circuit 305 by using the first output port.

Still referring to FIG. 2, the data processing unit 13 is further specifically configured to receive the effective value of the tested-cable voltage and determine the quantity of amplification times of the tested-cable voltage based on a ratio of an effective value of the first voltage $V_1$ to the effective value of the tested-cable voltage.

There is a problem that the coupling capacitance $C_x$ cannot be determined as it varies with an environmental change. Therefore, in this embodiment, by introducing the preset voltage $V_r$ to skip a process of determining the size of the coupling capacitance $C_x$, the correspondence between the actual voltage of the tested cable and the first voltage $V_1$ (the inducting voltage) is directly determined. Specifically, calculation may be performed in, but not limited to, the following manner:

Referring to FIG. 4B, when the second output port 39 is conducted to the fourth output port 41, the sub-amplification circuit 3021 inputs the preset voltage $V_r$ by using the fourth input port 35, and the subtractive operation circuit 3022 can also input the preset voltage $V_r$ by using the sixth output port 37. The sub-amplification circuit 3021 performs differential amplification on the inducting voltage and the preset voltage to obtain a third voltage $V_3$. The subtractive operation circuit 3022 is configured to calculate a difference between the third voltage $V_3$ and the preset voltage to obtain a fourth voltage $V_4$, and output the fourth voltage $V_4$ to the effective-value detection circuit 305 by using the first output port. As an optional implementation, the subtractive operation circuit 3022 may be an instrumentation amplifying circuit, and a gain of the subtractive operation circuit 3022 is G.

Specifically, if the actual voltage of the tested cable is $V_x$, the third voltage $V_3$ output by the sub-amplification circuit is: $V_3 = \sqrt{2}R_0C_x\left(V_r\omega_r\sin\left(\omega_r t+90\right)-V_x\omega_x\sin\left(\omega_x t+90\right)\right)+\sqrt{2}V_r\sin\left(\omega_r t\right)$ . $\omega_r$ is an angular frequency of the preset voltage $V_r$, and $\omega_x$ is an angular frequency of the actual voltage $V_x$ of the tested cable.

It can be learned that there are three voltage components in the third voltage $V_3$, two of the voltage components are components of the preset voltage in different phases: $\sqrt{2}R_0C_x\left(V_r\omega_r\sin\left(\omega_r t+90\right)\right)$ and $\sqrt{2}V_r\sin\left(\omega_r t\right)$ , and the other is a component of the actual voltage $V_x$ of the tested cable: $-\sqrt{2}R_0C_x\left(V_x\omega_x\sin\left(\omega_x t+90\right)\right)$ . A concept of this embodiment of this application is as follows: The effective-value detection circuit 305 separately extracts the two components $\sqrt{2}R_0C_x\left(V_r\omega_r\sin\left(\omega_r t+90\right)\right)$ and $-\sqrt{2}R_0C_x\left(V_x\omega_x\sin\left(\omega_x t+90\right)\right)$ , determines a median value X;

determines the effective value of the tested-cable voltage based on the median value X; determines, based on $V_1$ output by the phase-shift compensation circuit 303 in this case and the effective value of the actual voltage $V_x$ of the tested cable, a correspondence between the effective value of the actual voltage of the tested cable and the effective value of the first voltage $V_1$ (the inducting voltage), that is, the quantity of amplification times of the tested-cable voltage, so as to eliminate impact caused by a change of the coupling capacitance $C_x$, and further determines, based on the quantity of amplification times of the tested-cable voltage and the first voltage $V_1$ detected in real time, information such as an amplitude and a phase of the tested-cable voltage, and that harmonic information and the like in the tested cable are not lost.

However, as the third voltage includes the components of the preset voltage in different phases, the subtractive operation circuit 3022 in FIG. 4B is required to filter out the component $\sqrt{2}V_r \sin\left(\omega_r t\right)$ to obtain the fourth voltage $V_4$.

The subtractive operation circuit 3022 inputs the fourth voltage $V_4$ to the effective-value detection circuit. The fourth voltage is $V_4 = \sqrt{2}R_0 C_x \left(V_r \omega_r \sin\left(\omega_r t + 90\right) - V_x \omega_x \sin\left(\omega_x t + 90\right)\right)$.

The effective-value detection circuit 305 may extract the component $-\sqrt{2}R_0 C_x \left(V_x \omega_x \sin\left(\omega_x t + 90\right)\right)$ of the tested-cable voltage and the component $\sqrt{2}R_0 C_x \left(V_r \omega_r \sin\left(\omega_r t + 90\right)\right)$ of the preset voltage from the fourth voltage $V_4$, determine the effective value of the tested-cable voltage based on the component of the tested-cable voltage and the component of the preset voltage, and send the effective value of the tested-cable voltage to the data processing unit 13.

In the foregoing scenario, after extracting the component of the tested-cable voltage and the component of the preset voltage, the effective-value detection circuit 305 in FIG. 4A can calculate the median value X based on the component of the tested-cable voltage and the component of the preset voltage. Effective-value detection circuits 305 with different structures output different median values X, but there is a linear relationship between each of the median values X and the effective value of the tested-cable voltage. The effective-value detection circuit 305 may be various structures known by a person skilled in the art. This is not limited herein.

To determine the linear relationship between the median value X and the effective value of the tested-cable voltage, before actual use of the alternating-current energy detection apparatus, the second output port 32 of the single-pole double-throw switch 304 in FIG. 4B may be first conducted to the fourth output port 41, and a plurality of cables whose amplitudes and frequencies are known are detected to obtain a plurality of groups of data (effective values and median values X of the cables whose amplitudes and frequencies are all known). Base on the plurality of groups of data, a linear relationship between the median value X output by the effective-value detection circuit 305 and the effective value of the cable can be calculated: $V_{x0} = k_0 X + b_0$. $k_0$ and $b_0$ are coefficients of the linear relationship, and $V_{x0}$ is the effective value of the cable whose amplitude and frequency are all known. After the linear relationship between the median value X and the effective value of the cable is obtained, the actual tested cable is inserted into the alternating-current energy detection apparatus, an effective value of the tested-cable voltage is determined based on an median value X output in this case, and the effective value of the tested-cable voltage is sent to the data processing unit 13.

In an actual measurement scenario: When the second output port 32 of the single-pole double-throw switch 304 in FIG. 4B is conducted to the ground port 40, the sub-amplification circuit 3021 amplifies the inducting voltage by the first quantity of times, and inputs the second voltage $V_2$ to the subtractive operation circuit 3022. However, in this case, the sixth input port 37 of the subtractive operation circuit 3022 is grounded. Therefore, the subtractive operation circuit 3022 finally still outputs the second voltage $V_2$, and inputs the second voltage $V_2$ to the phase-shift compensation circuit 303. The phase-shift compensation circuit 303 amplifies the second voltage $V_2$ by the second quantity of times, and finally outputs the first voltage $V_1$. Base on the ratio of the effective value of the tested-cable voltage to the first voltage $V_1$, the quantity of amplification times of the tested-cable voltage is determined. The data processing unit 13 determines the tested-cable voltage value based on the quantity of amplification times of the tested-cable voltage and the first voltage $V_1$ detected in real time.

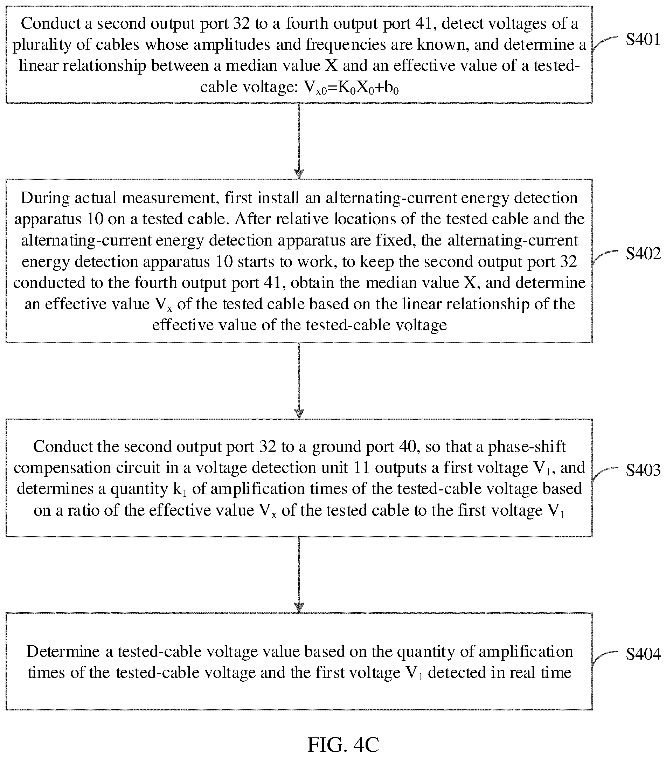

In conclusion, referring to the flowchart shown in FIG. 4C, the method for detecting the voltage of the tested cable by using the voltage detection unit 11 in this embodiment of this application mainly includes the following steps:

S401: Conduct the second output port 32 to the fourth output port 41, detect voltages of the plurality of cables whose amplitudes and frequencies are known, and determine the linear relationship between the median value X and the effective value of the tested-cable voltage: $V_x = k_0 X + b_0$.

S402: During actual measurement, first install the alternating-current energy detection apparatus 10 on the tested cable. After relative locations of the tested cable and the alternating-current energy detection apparatus are fixed, keep the second output port 32 conducted to the fourth output port 41, obtain the median value X, and determine the effective value $V_x$ of the tested cable based on the linear relationship of the effective value of the tested-cable voltage.

S403: Conduct the second output port 32 to the ground port 40, so that the phase-shift compensation circuit in the voltage detection unit 11 outputs the first voltage $V_1$, and determines the quantity of amplification times of the tested-cable voltage based on the ratio of the effective value $V_x$ of the tested cable to the first voltage $V_1$.

S404: Determine the tested-cable voltage value based on the quantity of amplification times of the tested-cable voltage and the first voltage $V_1$ detected in real time.

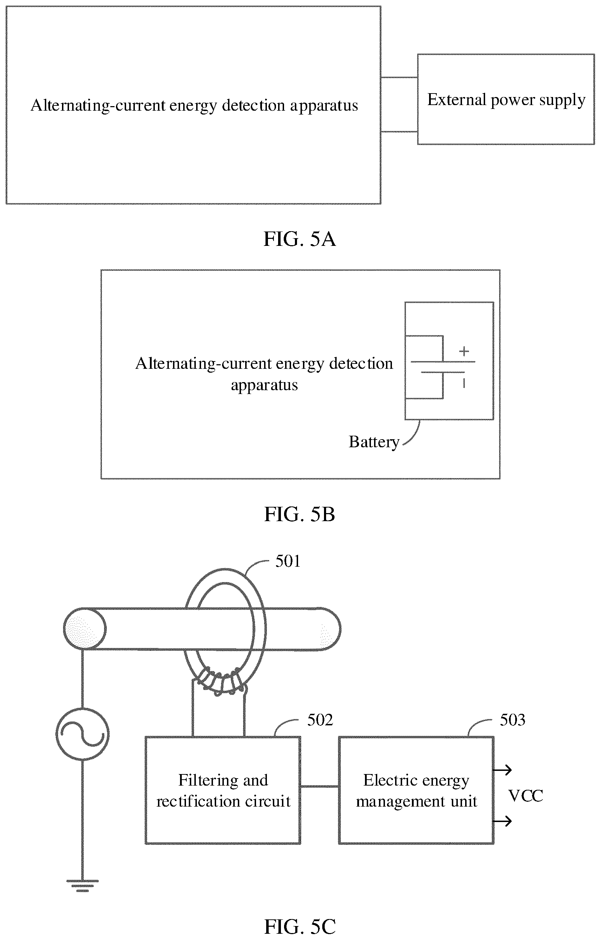

It should be noted that the alternating-current energy detection apparatus may further include a power supply unit. In a possible implementation, the power supply unit may be an external power supply. The external power supply can supply power to the voltage detection unit 11, the current detection unit 12, and the data processing unit 13 in the alternating-current energy detection apparatus 10. FIG. 5A is a schematic diagram of supplying power to the alternating-current energy detection apparatus by using an external power supply. However, a manner of using an external power supply leads to a relatively complex power supply form, and the alternating-current energy detection apparatus is limited by a location of the external power supply and can perform detection only near the power supply. Alternatively, referring to FIG. 5B, the power supply unit may be a built-in battery for the alternating-current energy detection apparatus, but a built-in battery has a service life problem, and needs to be repeatedly replaced for the alternating-current energy detection apparatus.

In some other embodiments, to resolve a problem that the alternating-current energy detection apparatus 10 is limited by a location of the external power supply or a problem that a built-in battery needs to be repeatedly replaced, an embodiment of this application further provides another power supply manner. The following specifically describes the power supply manner. Still referring to FIG. 2, the alternating-current energy detection apparatus may further include a power supply unit 14. FIG. 5C is a schematic diagram of installation of a power supply unit. The power supply unit 14 includes a power-draw transformer 501, a filtering and rectification circuit 502, and an electric energy management unit 503. The power-draw transformer 501 is configured to generate an induced current based on an actual current of the tested cable, and output the induced current to the filtering and rectification circuit. The filtering and rectification circuit 502 is configured to perform filtering and rectification on the induced current to obtain a power-supply current. The electric energy management unit 503 is configured to separately supply power to the voltage detection unit, the current detection unit, and the processing unit by using the power-supply current.

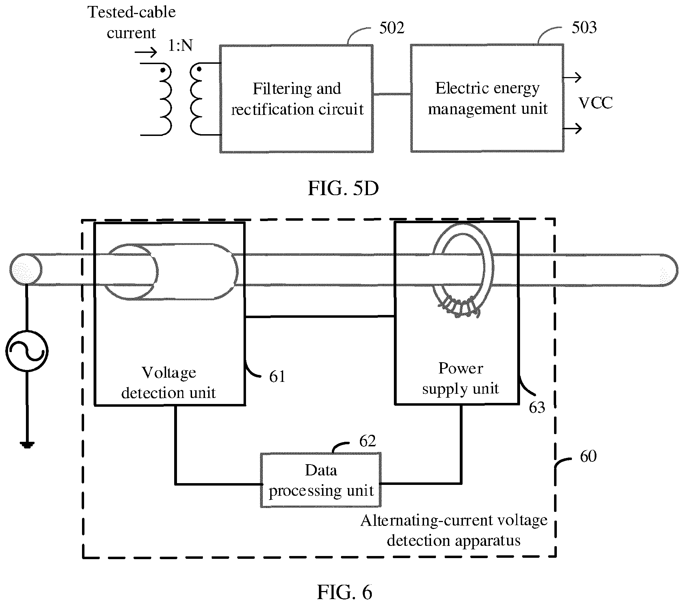

In a possible implementation, the power-draw transformer 501 is a toroidal iron core wound with at least one turn of coil, the toroidal iron core is a closed or non-closed structure, and the at least one turn of coil is configured to be connected to the filtering and rectification circuit. FIG. 5D is a schematic diagram of an equivalent structure of a power supply unit. A principle of the power-draw transformer 501 is similar to that of a common current transformer, but specific parameters are different, for example, a quantity of turns of coils winding the toroidal iron core is different. The induced current varies with a different quantity of turns, so that different coil-turn ratios can be set based on different power supply requirements. This should be known by a person skilled in the art, and details are not described herein.

In a possible implementation, the electric energy management unit is a direct current-to-direct current (direct current/direct current, DC/DC) DC/DC circuit. The DC/DC conversion circuit may include components such as a switching transistor, a diode, an inductor, and a capacitor. A work status of the DC/DC conversion circuit may be implemented by adjusting work statuses of these components (such as the switching transistor). The work status of the DC/DC conversion circuit may be: converting received electric energy into a working voltage that is suitable for the voltage detection unit 11, the current detection unit 12, and the data processing unit 13. Specifically, the switching transistor in the DC/DC conversion circuit is a metal oxide semiconductor (metal oxide semiconductor, MOS) transistor, or may be a bipolar junction transistor (bipolar junction transistor, BJT), or certainly may be another component that can implement a switching function. This is not specifically limited in this application.

In a possible implementation, the electric energy management unit may further include a battery module. The DC/DC conversion circuit converts received electric energy and outputs the converted electric energy to the battery module. In this case, the DC/DC conversion circuit is in a charging state. In addition, when the voltage detection unit 11, the current detection unit 12, and the data processing unit 13 are in a working state, the DC/DC conversion circuit converts electric energy stored in the battery module into a voltage that is suitable for the voltage detection unit 11, the current detection unit 12, and the data processing unit 13 for output. In this case, the DC/DC conversion circuit is in a discharging state.

Based on the alternating-current energy detection apparatus provided in the foregoing embodiment, the alternating-current energy detection apparatus provided in this application can prevent a problem that an installation location of the alternating-current energy detection apparatus is limited by electrical connection points used for performing alternating-current voltage and current detection. In addition, there is no electrical connection between the alternating-current energy detection apparatus and the tested cable. Under a premise of real-time detection of information such as an amplitude and a phase of a measured voltage and all harmonics of the tested cable, a production compliance level of the detection apparatus can be increased, and costs of the alternating-current energy detection apparatus can be reduced. Further, the alternating-current energy detection apparatus provided in this application may alternatively draw power in a manner without electrical connection, so that the alternating-current energy detection apparatus is not limited by a location of an external power supply and can work normally at any location of the tested cable. In addition, based on the voltage detection unit in the alternating-current energy detection apparatus in this application, a calibration method for voltage detection provided in this embodiment of this application may be used to eliminate impact on voltage detection precision that is caused by a change of an external environment condition such as the location of the tested cable in the voltage sensor or a cable diameter, so as to obtain a more accurate voltage detection result and further obtain a more accurate electric energy detection result.

Based on a same technical concept, this application further provides an alternating-current voltage detection apparatus. Referring to FIG. 6, the alternating-current voltage detection apparatus 60 includes a voltage detection unit 61 and a data processing unit 62. The voltage detection unit 61 forms a coupling capacitance together with a tested cable, and is configured to obtain a first voltage based on an actual voltage of the tested cable and the coupling capacitance, and output the first voltage to the data processing unit. The data processing unit is 62 configured to receive the first voltage and determine a first voltage value; and calculate a product of the first voltage value and a quantity of amplification times of a tested-cable voltage, and determine a tested-cable voltage value.

In a possible implementation, the voltage detection unit 61 includes a voltage sensor, an amplification circuit, and a phase-shift compensation circuit. The amplification circuit includes a first input port, a second input port, and a first output port. The first input port is connected to the voltage sensor, the second input port is connected to a ground cable, and the first output port is connected to the phase-shift compensation circuit.

The voltage sensor is a conductive tubular structure, the tested cable runs through the voltage sensor, and the voltage sensor forms a coupling capacitance together with the tested cable. The voltage sensor is configured to generate an inducting voltage based on the actual voltage of the tested cable and the coupling capacitance. The amplification circuit is configured to amplify the inducting voltage by a first quantity of times, and output a second voltage to the phase-shift compensation circuit by using the output port. The phase-shift compensation circuit is configured to perform a phase shift on the second voltage, amplify the second voltage by a second quantity of times, and output the first voltage.

In a possible implementation, the phase-shift compensation circuit is specifically configured to lag a phase of the second voltage by 90°.

In a possible implementation, the voltage sensor is a closed or non-closed tubular structure. The voltage sensor is prepared by using a metal material.

In a possible implementation, the voltage detection unit further includes a single-pole double-throw switch and an effective-value detection circuit.

The single-pole double-throw switch includes a second output port, a ground port, and a preset-voltage input port. The single-pole double-throw switch is bridged between the second input port and the ground cable, the second output port is connected to the second input port, the preset-voltage input port is configured to receive an input preset voltage, and the ground port is connected to the ground cable.

The amplification circuit includes a sub-amplification circuit and a subtractive operation circuit.

The sub-amplification circuit includes a third input port, a fourth input port, and a third output port. The subtractive operation circuit includes a fifth input port, a sixth output port, and a fourth output port. The first input port is connected to the third input port, the second input port is separately connected to the fourth input port and the sixth input port, the third output port is connected to the fifth input port, and the fourth output port is connected to the first output port. The first output port is further connected to the effective-value detection circuit.

When the second output port is conducted to the ground port, the sub-amplification circuit is configured to amplify the inducting voltage by the first quantity of times, and output the second voltage to the phase-shift compensation circuit. When the second output port is conducted to the preset-voltage input port, the sub-amplification circuit is configured to perform differential amplification on the inducting voltage and the preset voltage by the first quantity of times to obtain a third voltage, and the subtractive operation circuit is configured to calculate a difference between the third voltage and the preset voltage to obtain a fourth voltage, and output the fourth voltage to the effective-value detection circuit by using the first output port.

The effective-value detection circuit is configured to receive the fourth voltage, separately extract a component of the tested-cable voltage and a component of the preset voltage from the fourth voltage, determine an effective value of the tested-cable voltage based on the component of the tested-cable voltage and the component of the preset voltage, and send the effective value of the tested-cable voltage to the data processing unit.

The data processing unit 62 is specifically configured to receive the effective value of the tested-cable voltage; and determine the quantity of amplification times of the tested-cable voltage based on a ratio of an effective value of the first voltage to the effective value of the tested-cable voltage.

For a specific manner of voltage detection on the tested cable by the voltage detection unit 61, refer to the flowchart shown in FIG. 4C. Details are not described herein again.

In a possible implementation, the apparatus further includes a power supply unit 63. The power supply unit is configured to supply power to the voltage detection unit and the data processing unit.

In a possible implementation, the power supply unit 63 includes a power-draw transformer, a filtering and rectification circuit, and an electric energy management unit. The power-draw transformer is configured to generate an induced current based on a current of the tested cable, and output the induced current to the filtering and rectification circuit. The filtering and rectification circuit is configured to perform filtering and rectification on the induced current to obtain a power-supply current. The electric energy management unit is configured to separately supply power to the voltage detection unit and the processing unit by using the power-supply current.

In a possible implementation, the power-draw transformer is a toroidal iron core wound with at least one turn of coil, the toroidal iron core is a closed or non-closed structure, and the at least one turn of coil is configured to be connected to the filtering and rectification circuit. The electric energy management unit is a direct current-to-direct current DC/DC circuit.

In addition, based on the structure of the voltage detection unit in FIG. 3A, this application further provides an alternating-current energy detection method. The method includes: receiving a first voltage and a tested-cable current, and determining a first voltage value and a tested-cable current value; calculating a product of the first voltage value and a quantity of amplification times of a tested-cable voltage, and determining a tested-cable voltage value; and calculating, based on the tested-cable voltage value and the tested-cable current value, electric energy transmitted by a tested cable.

In a possible implementation, the method further includes: receiving an effective value of the tested-cable voltage; and determining the quantity of amplification times of the tested-cable voltage based on a ratio of an effective value of the first voltage to the effective value of the tested-cable voltage.

In addition, this application provides an alternating-current voltage detection method. The method includes: receiving a first voltage, and determining a first voltage value; and calculating a product of the first voltage value and a quantity of amplification times of a tested-cable voltage, and determining a tested-cable voltage value.

In a possible implementation, the method further includes: receiving an effective value of the tested-cable voltage; and determining the quantity of amplification times of the tested-cable voltage based on a ratio of an effective value of the first voltage to the effective value of the tested-cable voltage.

The foregoing is described from a perspective of a method embodiment. It can be understood that, to implement the foregoing method, the alternating-current energy detection apparatus may include a hardware structure and/or a software module corresponding to executing each function. A person skilled in the art should easily be aware that, in combination with units and algorithm steps of the examples described in the embodiments disclosed in this specification, this application may be implemented by hardware or a combination of hardware and computer software. Whether a function is performed by hardware or hardware driven by computer software depends on particular applications and design constraints of the technical solutions. A person skilled in the art may use different methods to implement the described functions for each particular application, but it should not be considered that the implementation goes beyond the scope of this application.

Based on the foregoing embodiments, an embodiment of this application further provides a computer program. When the computer program runs on a computer, the computer is enabled to perform the alternating-current energy detection method provided in the foregoing embodiment, or the computer is enabled to perform the alternating-current voltage detection method provided in the foregoing embodiment.

Based on the foregoing embodiments, an embodiment of this application further provides a computer readable storage medium. The computer readable storage medium stores a computer program. When the computer program is executed by a computer, the computer is enabled to perform the alternating-current energy detection method provided in the foregoing embodiment, or the computer is enabled to perform the alternating-current voltage detection method provided in the foregoing embodiment.

The storage medium may be any available medium accessible to a computer. The following provides an example but does not impose a limitation: The computer-readable medium may include a RAM, a ROM, an EEPROM, a CD-ROM, another optical disc storage, a disk storage medium, or another magnetic storage device, or any other medium that can carry or store expected program code in a form of an instruction or a data structure and can be accessed by a computer.

Based on the foregoing embodiments, an embodiment of this application further provides a chip. The chip is configured to read a computer program stored in a memory, so as to implement the alternating-current energy detection method provided in the foregoing embodiment, or implement the alternating-current voltage detection method provided in the foregoing embodiment.

Based on the foregoing embodiments, an embodiment of this application provides a chip system. The chip system includes a processor, configured to support a computer apparatus to implement the alternating-current energy detection method provided in the foregoing embodiment, or to implement the alternating-current voltage detection method provided in the foregoing embodiment. In a possible design, the chip system further includes a memory, and the memory is configured to store a program and data that are necessary for the computer apparatus. The chip system may include a chip, or may include a chip and another discrete component.

All or some of the foregoing embodiments may be implemented by using software, hardware, firmware, or any combination thereof. When software is used to implement the embodiments, all or some of the embodiments may be implemented in a form of a computer program product. The computer program product includes one or more computer instructions. When the computer program instructions are loaded and executed on a computer, all or some of the procedures or functions according to the embodiments of this application are generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid state disk (Solid State Disk, SSD)), or the like.

The various illustrative logical units and circuits described in the embodiments of this application may implement or operate the described functions by using a general-purpose processor, a digital signal processor, an application-specific integrated circuit (ASIC), a field programmable gate array (FPGA) or another programmable logical apparatus, a discrete gate or transistor logic, a discrete hardware component, or a design of any combination thereof. The general-purpose processor may be a microprocessor. Optionally, the general-purpose processor may alternatively be any conventional processor, controller, microcontroller, or state machine. The processor may also be implemented by a combination of computing apparatuses, such as a digital signal processor and a microprocessor, a plurality of microprocessors, one or more microprocessors with a digital signal processor core, or any other similar configuration.

Steps of the methods or algorithms described in the embodiments of this application may be directly embedded into hardware, a software unit executed by a processor, or a combination thereof. The software unit may be stored in a RAM, a flash memory, a ROM, an EPROM, an EEPROM, a register, a hard disk, a removable magnetic disk, a CD-ROM, or a storage medium of any other form in the art. For example, the storage medium may connect to a processor, so that the processor can read information from the storage medium and write information into the storage medium. Optionally, the storage medium may alternatively be integrated into the processor. The processor and the storage medium may be disposed in the ASIC.

These computer program instructions may alternatively be loaded onto a computer or another programmable data processing device, so that a series of operation steps are performed on the computer or the another programmable device, to generate computer-implemented processing. Therefore, the instructions executed on the computer or the another programmable device provide steps for implementing a specified function in one or more processes in the flowcharts and/or in one or more blocks in the block diagrams.

Although this application is described with reference to specific features and the embodiments thereof, it is clear that various modifications and combinations may be made to them without departing from the spirit and scope of this application. Correspondingly, the specification and accompanying drawings are merely example description of this application defined by the appended claims, and is considered as any of or all modifications, variations, combinations or equivalents that cover the scope of this application. It is clear that a person skilled in the art can make various modifications and variations to this application without departing from the scope of this application. This application is intended to cover these modifications and variations of this application provided that they fall within the scope of protection defined by the following claims and their equivalent technologies.

## Claims

1. An alternating-current energy detection apparatus, wherein the apparatus comprises a voltage detection unit, a current detection unit, and a data processing unit;

   the voltage detection unit forms a coupling capacitance together with a tested cable, and is configured to obtain a first voltage based on an actual voltage of the tested cable and the coupling capacitance, and output the first voltage to the data processing unit;
   the current detection unit is configured to detect a tested-cable current, and output the tested-cable current to the data processing unit; and

the data processing unit is configured to receive the first voltage and the tested-cable current, and determine a first voltage value and a tested-cable current value; calculate a product of the first voltage value and a quantity of amplification times of a tested-cable voltage, and determine a tested-cable voltage value; and calculate, based on the tested-cable voltage value and the tested-cable current value, electric energy transmitted by the tested cable.

2. The apparatus according to claim 1, wherein the voltage detection unit comprises a voltage sensor, an amplification circuit, and a phase-shift compensation circuit, and the amplification circuit comprises a first input port, a second input port, and a first output port, wherein the first input port is connected to the voltage sensor, the second input port is connected to a ground cable, and the first output port is connected to the phase-shift compensation circuit;

the voltage sensor is a conductive tubular structure, the tested cable runs through the voltage sensor, and the voltage sensor forms a coupling capacitance together with the tested cable; and the voltage sensor is configured to generate an inducting voltage based on the actual voltage of the tested cable and the coupling capacitance; the amplification circuit is configured to amplify the inducting voltage by a first quantity of times, and output a second voltage to the phase-shift compensation circuit by using the output port; and the phase-shift compensation circuit is configured to perform a phase shift on the second voltage, amplify the second voltage by a second quantity of times, and output the first voltage.

3. The apparatus according to claim 2, wherein the phase-shift compensation circuit is specifically configured to lag a phase of the second voltage by 90°.

4. The apparatus according to claim 2 or 3, wherein the voltage sensor is a closed or non-closed tubular structure; and the voltage sensor is prepared by using a metal material.

5. The apparatus according to any one of claims 2 to 4, wherein the voltage detection unit further comprises a single-pole double-throw switch and an effective-value detection circuit;

the single-pole double-throw switch comprises a second output port, a ground port, and a preset-voltage input port; and the single-pole double-throw switch is bridged between the second input port and the ground cable, the second output port is connected to the second input port, the preset-voltage input port is configured to receive an input preset voltage, and the ground port is connected to the ground cable; the amplification circuit comprises a sub-amplification circuit and a subtractive operation circuit; the sub-amplification circuit comprises a third input port, a fourth input port, and a third output port; the subtractive operation circuit comprises a fifth input port, a sixth output port, and a fourth output port; the first input port is connected to the third input port, the second input port is separately connected to the fourth input port and the sixth input port, the third output port is connected to the fifth input port, and the fourth output port is connected to the first output port; and the first output port is further connected to the effective-value detection circuit; when the second output port is conducted to the ground port, the sub-amplification circuit is configured to amplify the inducting voltage by the first quantity of times, and output the second voltage to the phase-shift compensation circuit; and when the second output port is conducted to the preset-voltage input port, the sub-amplification circuit is configured to perform differential amplification on the inducting voltage and the preset voltage by the first quantity of times to obtain a third voltage, and the subtractive operation circuit is configured to calculate a difference between the third voltage and the preset voltage to obtain a fourth voltage, and output the fourth voltage to the effective-value detection circuit by using the first output port; the effective-value detection circuit is configured to receive the fourth voltage, separately extract a component of the tested-cable voltage and a component of the preset voltage from the fourth voltage, determine an effective value of the tested-cable voltage based on the component of the tested-cable voltage and the component of the preset voltage, and send the effective value of the tested-cable voltage to the data processing unit; and the data processing unit is specifically configured to:

receive the effective value of the tested-cable voltage; and determine the quantity of amplification times of the tested-cable voltage based on a ratio of an effective value of the first voltage to the effective value of the tested-cable voltage.

6. The apparatus according to any one of claims 1 to 5, wherein the apparatus further comprises a power supply unit, and the power supply unit is configured to supply power to the voltage detection unit and the data processing unit.

7. The apparatus according to claim 6, wherein the power supply unit comprises a power-draw transformer, a filtering and rectification circuit, and an electric energy management unit;

the power-draw transformer is configured to generate an induced current based on an actual current of the tested cable, and output the induced current to the filtering and rectification circuit;

the filtering and rectification circuit is configured to perform filtering and rectification on the induced current to obtain a power-supply current; and

the electric energy management unit is configured to separately supply power to the voltage detection unit, the current detection unit, and the processing unit by using the power-supply current.

8. The apparatus according to claim 7, wherein the power-draw transformer is a toroidal iron core wound with at least one turn of coil, the toroidal iron core is a closed or non-closed structure, and the at least one turn of coil is configured to be connected to the filtering and rectification circuit; and the electric energy management unit is a direct current-to-direct current DC/DC circuit.

9. An alternating-current voltage detection apparatus, wherein the apparatus comprises a voltage detection unit and a data processing unit;

the voltage detection unit forms a coupling capacitance together with a tested cable, and is configured to obtain a first voltage based on an actual voltage of the tested cable and the coupling capacitance, and output the first voltage to the data processing unit; and

the data processing unit is configured to receive the first voltage and determine a first voltage value; and calculate a product of the first voltage value and a quantity of amplification times of a tested-cable voltage, and determine a tested-cable voltage value.

10. The apparatus according to claim 9, wherein the voltage detection unit comprises a voltage sensor, an amplification circuit, and a phase-shift compensation circuit, and the amplification circuit comprises a first input port, a second input port, and a first output port, wherein the first input port is connected to the voltage sensor, the second input port is connected to a ground cable, and the first output port is connected to the phase-shift compensation circuit;

the voltage sensor is a conductive tubular structure, the tested cable runs through the voltage sensor, and the voltage sensor forms a coupling capacitance together with the tested cable; and the voltage sensor is configured to generate an inducting voltage based on the actual voltage of the tested cable and the coupling capacitance;

the amplification circuit is configured to amplify the inducting voltage by a first quantity of times, and output a second voltage to the phase-shift compensation circuit by using the output port; and

the phase-shift compensation circuit is configured to perform a phase shift on the second voltage, amplify the second voltage by a second quantity of times, and output the first voltage.

11. The apparatus according to claim 10, wherein the phase-shift compensation circuit is specifically configured to lag a phase of the second voltage by 90°.

12. The apparatus according to claim 10 or 11, wherein the voltage sensor is a closed or non-closed tubular structure; and the voltage sensor is prepared by using a metal material.

13. The apparatus according to any one of claims 10 to 12, wherein the voltage detection unit further comprises a single-pole double-throw switch and an effective-value detection circuit;

the single-pole double-throw switch comprises a second output port, a ground port, and a preset-voltage input port; and the single-pole double-throw switch is bridged between the second input port and the ground cable, the second output port is connected to the second input port, the preset-voltage input port is configured to receive an input preset voltage, and the ground port is connected to the ground cable;

the amplification circuit comprises a sub-amplification circuit and a subtractive operation circuit;

the sub-amplification circuit comprises a third input port, a fourth input port, and a third output port; the subtractive operation circuit comprises a fifth input port, a sixth output port, and a fourth output port; the first input port is connected to the third input port, the second input port is separately connected to the fourth input port and the sixth input port, the third output port is connected to the fifth input port, and the fourth output port is connected to the first output port; and the first output port is further connected to the effective-value detection circuit;

when the second output port is conducted to the ground port, the sub-amplification circuit is configured to amplify the inducting voltage by the first quantity of times, and output the second voltage to the phase-shift compensation circuit; and when the second output port is conducted to the preset-voltage input port, the sub-amplification circuit is configured to perform differential amplification on the inducting voltage and the preset voltage by the first quantity of times to obtain a third voltage, and the subtractive operation circuit is configured to calculate a difference between the third voltage and the preset voltage to obtain a fourth voltage, and output the fourth voltage to the effective-value detection circuit by using the first output port;

the effective-value detection circuit is configured to receive the fourth voltage, separately extract a component of the tested-cable voltage and a component of the preset voltage from the fourth voltage, determine an effective value of the tested-cable voltage based on the component of the tested-cable voltage and the component of the preset voltage, and send the effective value of the tested-cable voltage to the data processing unit; and

the data processing unit is specifically configured to:

> receive the effective value of the tested-cable voltage; and
> determine the quantity of amplification times of the tested-cable voltage based on a ratio of an effective value of the first voltage to the effective value of the tested-cable voltage.

14. The apparatus according to any one of claims 9 to 13, wherein the apparatus further comprises a power supply unit, and the power supply unit is configured to supply power to the voltage detection unit and the data processing unit.

15. The apparatus according to claim 14, wherein the power supply unit comprises a power-draw transformer, a filtering and rectification circuit, and an electric energy management unit;

> the power-draw transformer is configured to generate an induced current based on a current of the tested cable, and output the induced current to the filtering and rectification circuit;
> the filtering and rectification circuit is configured to perform filtering and rectification on the induced current to obtain a power-supply current; and
> the electric energy management unit is configured to separately supply power to the voltage detection unit and the processing unit by using the power-supply current.

16. The apparatus according to claim 15, wherein the power-draw transformer is a toroidal iron core wound with at least one turn of coil, the toroidal iron core is a closed or non-closed structure, and the at least one turn of coil is configured to be connected to the filtering and rectification circuit; and the electric energy management unit is a direct current-to-direct current DC/DC circuit.

17. An alternating-current energy detection method, wherein the method comprises:

> receiving a first voltage and a tested-cable current, and determining a first voltage value and a tested-cable current value;
> calculating a product of the first voltage value and a quantity of amplification times of a tested-cable voltage, and determining a tested-cable voltage value; and
> calculating, based on the tested-cable voltage value and the tested-cable current value, electric energy transmitted by a tested cable.

18. The method according to claim 17, wherein the method further comprises:

> receiving an effective value of the tested-cable voltage; and
> determining the quantity of amplification times of the tested-cable voltage based on a ratio of an effective value of the first voltage to the effective value of the tested-cable voltage.

19. An alternating-current voltage detection method, wherein the method comprises:

> receiving a first voltage, and determining a first voltage value; and
> calculating a product of the first voltage value and a quantity of amplification times of a tested-cable voltage, and determining a tested-cable voltage value.

20. The method according to claim 19, wherein the method further comprises:

> receiving an effective value of the tested-cable voltage; and

determining the quantity of amplification times of the tested-cable voltage based on a ratio of an effective value of the first voltage to the effective value of the tested-cable voltage.

Live wire

Neutral wire

Earth

Risistor-based voltage division and voltage step down

↓

Signal processing

↓

ADC

FIG. 1A

Live wire

Neutral wire

Earth

Step-down
transformer

Signal processing

ADC

FIG. 1B

FIG. 2

FIG. 3A

Copper foil

Tested cable

$C_x$

FIG. 3B

$R_0$

$C_x$

Inducting voltage

Second voltage

FIG. 3C

$R_1$

Second
voltage $C_1$

$R_2$

$R_3$

First
voltage

FIG. 3D

301

302

303

31

33

Amplification
circuit

Phase-shift
compensation
circuit

32

39

304

305

40

41

Effective-value
detection circuit

FIG. 4A

FIG. 4B

Conduct a second output port 32 to a fourth output port 41, detect voltages of a plurality of cables whose amplitudes and frequencies are known, and determine a linear relationship between a median value X and an effective value of a tested-cable voltage: $V_{x0}=K_0X_0+b_0$ — S401

During actual measurement, first install an alternating-current energy detection apparatus 10 on a tested cable. After relative locations of the tested cable and the alternating-current energy detection apparatus are fixed, the alternating-current energy detection apparatus 10 starts to work, to keep the second output port 32 conducted to the fourth output port 41, obtain the median value X, and determine an effective value $V_x$ of the tested cable based on the linear relationship of the effective value of the tested-cable voltage — S402

Conduct the second output port 32 to a ground port 40, so that a phase-shift compensation circuit in a voltage detection unit 11 outputs a first voltage $V_1$, and determines a quantity $k_1$ of amplification times of the tested-cable voltage based on a ratio of the effective value $V_x$ of the tested cable to the first voltage $V_1$ — S403

Determine a tested-cable voltage value based on the quantity of amplification times of the tested-cable voltage and the first voltage $V_1$ detected in real time — S404

FIG. 4C

Alternating-current energy detection apparatus

External power supply

FIG. 5A

Alternating-current energy detection apparatus

+

|

Battery

FIG. 5B

501

502

Filtering and rectification circuit

503

Electric energy management unit

VCC

FIG. 5C

FIG. 5D

FIG. 6

<div align="center">INTERNATIONAL SEARCH REPORT</div>

| | International application No. |
|---|---|
| | **PCT/CN2020/134698** |

**A.    CLASSIFICATION OF SUBJECT MATTER**

G01R 15/16(2006.01)i

According to International Patent Classification (IPC) or to both national classification and IPC

**B.    FIELDS SEARCHED**

Minimum documentation searched (classification system followed by classification symbols)

G01R

Documentation searched other than minimum documentation to the extent that such documents are included in the fields searched

Electronic data base consulted during the international search (name of data base and, where practicable, search terms used)

CNPAT, WPI, EPODOC, CNKI, IEEE: 电容, 耦合, 无接触, 电压, 电流, 功率, 电能, 有效值, capacit+, contactless, voltage, current, power, rms

**C.    DOCUMENTS CONSIDERED TO BE RELEVANT**

| Category* | Citation of document, with indication, where appropriate, of the relevant passages | Relevant to claim No. |
|---|---|---|
| X | WO 2020109283 A2 (TRUST POWER LTD.) 04 June 2020 (2020-06-04) <br> description page 8 line 18 - page 25 line 31, figures 1-9 | 1-4, 6-12, 14-20 |
| A | WO 2020109283 A2 (TRUST POWER LTD.) 04 June 2020 (2020-06-04) <br> entire document | 5, 13 |
| X | WO 2020001933 A1 (SIEMENS MOBILITY GMBH) 02 January 2020 (2020-01-02) <br> description page 6 line 25 - page 10 line 38, figures 1-5 | 1-4, 6-12, 14-20 |
| A | WO 2020001933 A1 (SIEMENS MOBILITY GMBH) 02 January 2020 (2020-01-02) <br> entire document | 5, 13 |
| X | CN 108072789 A (FLUKE CORPORATION) 25 May 2018 (2018-05-25) <br> description paragraphs [0085]-[0276], figures 1A-29 | 1-4, 6-12, 14-20 |
| A | CN 108072789 A (FLUKE CORPORATION) 25 May 2018 (2018-05-25) <br> entire document | 5, 13 |
| X | CN 102510284 A (DELTA-CIMIC ELECTRONICS CO., LTD.) 20 June 2012 (2012-06-20) <br> description, paragraphs [0058]-[0112], and figures 1-4 | 17-20 |
| A | CN 102510284 A (DELTA-CIMIC ELECTRONICS CO., LTD.) 20 June 2012 (2012-06-20) <br> entire document | 1-16 |

☐ Further documents are listed in the continuation of Box C.      ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **06 August 2021** | **26 August 2021** |

| Name and mailing address of the ISA/CN | Authorized officer |
|---|---|
| **China National Intellectual Property Administration (ISA/ CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2020/134698**

| Patent document cited in search report | | | Publication date (day/month/year) | Patent family member(s) | | | Publication date (day/month/year) |
|---|---|---|---|---|---|---|---|
| WO | 2020109283 | A2 | 04 June 2020 | WO | 2020109283 | A3 | 06 August 2020 |
| | | | | GB | 2579376 | B | 30 December 2020 |
| | | | | GB | 2579376 | A | 24 June 2020 |
| | | | | GB | 201819468 | D0 | 16 January 2019 |
| | | | | GB | 2585135 | A | 30 December 2020 |
| WO | 2020001933 | A1 | 02 January 2020 | EP | 3788388 | A1 | 10 March 2021 |
| | | | | DE | 102018210568 | A1 | 02 January 2020 |
| CN | 108072789 | A | 25 May 2018 | US | 2018136257 | A1 | 17 May 2018 |
| | | | | EP | 3321696 | A1 | 16 May 2018 |
| | | | | TW | 201830030 | A | 16 August 2018 |
| | | | | JP | 2018105850 | A | 05 July 2018 |
| | | | | EP | 3321696 | B1 | 28 August 2019 |
| | | | | US | 10352967 | B2 | 16 July 2019 |
| CN | 102510284 | A | 20 June 2012 | CN | 102510284 | B | 06 May 2015 |

Form PCT/ISA/210 (patent family annex) (January 2015)